Europäisches Patentamt

European Patent Office

Office européen des brevets

(19)

(11) Veröffentlichungsnummer: **0 339 317 B1**

(12) **EUROPÄISCHE PATENTSCHRIFT**

(45) Veröffentlichungstag der Patentschrift:
**19.02.92 Patentblatt 92/08**

(21) Anmeldenummer: **89105953.7**

(22) Anmeldetag: **05.04.89**

(51) Int. Cl.⁵: $G06G\ 7/20$, $G01R\ 1/36$

(54) **Quadrierschaltung.**

(30) Priorität: **21.04.88 DE 3813413**

(43) Veröffentlichungstag der Anmeldung:
**02.11.89 Patentblatt 89/44**

(45) Bekanntmachung des Hinweises auf die
Patenterteilung:
**19.02.92 Patentblatt 92/08**

(84) Benannte Vertragsstaaten:
**DE FR GB IT**

(56) Entgegenhaltungen:
**EP-A- 0 167 884**
**DE-B- 2 412 528**
**NATIONAL SEMICONDUCTOR LINEAR DATA-**
**BOOK, 1982, Seiten 1,2,8-251 - 8-257, Santa**
**Clara, California, US**

(56) Entgegenhaltungen:
**ELECTRONIC DESIGN, Band 26, Nr. 25, 6.**
**Dezember 1978, Seiten 70-76; R.A. PEASE:**
**"Versatile monolithic v/f's can compute as**
**well as convert with high accuracy"**
**(ATM) ARCHIV FÜR TECHNISCHES MESSEN,**
**Band 377, Blatt V 327, Februar 1967, Seiten**
**25-28; O. LOH et al.: "Eine elektronische Re-**
**cheneinheit zur fortlaufenden Registrierung**
**des i2 t-Wertes mit Schleifenoszillographen"**

(73) Patentinhaber: **TELEFUNKEN electronic**
**GmbH**
**Theresienstrasse 2**
**W-7100 Heilbronn (DE)**

(72) Erfinder: **Nutz, Karl-Diether, Dipl.-Ing.**
**Blumenstrasse 33**
**W-7101 Oedheim (DE)**

(74) Vertreter: **Maute, Hans-Jürgen, Dipl.-Ing.**
**TELEFUNKEN electronic GmbH**
**Theresienstrasse 2**
**W-7100 Heilbronn (DE)**

## Beschreibung

Die Erfindung betrifft eine Quadrierschaltung, die eine Ausgangsspannung liefert, deren Wert proportional zum Quadrat des Wertes der Eingangsspannung ist, sowie deren Verwendung in einer $i^2t$-Schutzschaltung.

Der Ausdruck $i^2t$, wobei i der Laststrom eines elektrischen Verbrauchers und t die zugehörige Zeitdauer darstellt, läßt Rückschlüsse auf das Temperaturverhalten eines elektrischen Verbrauchers, beispielsweise eines Gleichstrommotors, zu.

Aus der DE-B-2 412 528 ist eine Quadrierschaltung bekannt, die aus einem astabilen Multivibrator, einem Operationsverstärker und einem RC-Glied aufgebaut ist. Die Eingangsspannung wird sowohl dem Multivibrator als auch über Vorwiderstände den beiden Eingängen des Operationsverstärkers zugeführt, der über einen Widerstand gegengekoppelt ist. Einer der Eingänge des Operationsverstärkers läßt sich über einen pnp-Schalttransistor, der mit der Ausgangsfrequenz des Multivibrators getaktet wird, mit dem Bezugspotential der Schaltung verbinden. Der Kondensator des RC-Gliedes wird über dessen Widerstand mit der Eingangsspannung als Ladespannung geladen, falls der Schalttransistor durch den Multivibrator in den sperrenden Zustand gesteuert wird. Eine Entladung des Kondensators erfolgt erst, wenn der Multivibrator den Schalttransistor durchsteuert, so daß der eine Eingang des Operationsverstärkers auf dem Bezugspotential liegt. Die am Kondensator abgreifbare Ausgangsspannung ist somit proportional zum Quadrat der Eingangsspannung, da die Ladespannung proportional zur Eingangsspannung zunimmt und ebenso mit zunehmender Eingangsspannung die Entladedauer kürzer wird. Der astabile Multivibrator erzeugt also beispielsweise ein rechteckförmiges Ausgangssignal konstanter Frequenz, wobei sich das Tastverhältnis in der Weise mit zunehmender Eingangsspannung ändert, daß die Breite der den Schalttransistor durchsteuernden Impulse kleiner wird. Diese bekannte Quadrierschaltung wird zum Aufbau eines Strahlungspyrometers mit linearisiertem Ausgangssignal verwendet, das einen Strahlungsdetektor enthält, dessen elektrisches, der vierten Potenz der Temperatur des Strahlers proportionales Ausgangssignal zwei in Reihe geschaltete, Quadratwurzel bildende Radizierstufen speist. Der Nachteil dieser bekannten Schaltung besteht darin, daß ein astabiler Multivibrator mit speziellen Eigenschaften erforderlich ist, wodurch diese Schaltung in ihrer Herstellung teuer wird.

Der vorliegenden Erfindung liegt die Aufgabe zugrunde, eine Quadrierschaltung der eingangs beschriebenen Art anzugeben, die den o. g. Nachteil vermeidet.

Diese Aufgabe wird erfindungsgemäß gelöst durch die Merkmale des Patentanspruches 1.

Die erfindungsgemäße Quadrierschaltung verwendet also einen spannungsgesteuerten Oszillator, der ein zur Eingangsspannung proportionales Frequenzsignal liefert, das als rechteckförmiges Spannungssignal ein konstantes Tastverhältnis aufweist. Damit kann für diesen spannungsgesteuerten Oszillator ein handelsübliches Bauteil verwendet werden. Die erfindungsgemäße Schaltung zeichnet sich ferner dadurch aus, daß der Spannungs-Frequenz/Strom-Wandler ein zum Quadrat der Eingangsspannung proportionales Stromsignal liefert, das mittels einer Impedanz in das zu dem Stromsignal proportionale Ausgangsspannungssignal gewandelt wird.

In einer ersten vorteilhaften erfindungsgemäßen Ausführungsform besteht die Impedanz aus einem RC-Netzwerk.

Gemäß einer weiteren bevorzugten Ausbildungsform der Erfindung arbeitet der Spannungs-Frequenz/Strom-Wandler nach dem Prinzip der Ladungspumpe.

Die erfindungsgemäße Quadrierschaltung kann in einer $i^2t$-Schutzschaltung zum Schutz eines elektrischen Verbrauchers vor Überlastung Verwendung finden. Eine vorteilhafte Ausbildung einer solchen $i^2t$-Schutzschaltung besteht darin, daß der über einen Meßwiderstand geführte Laststrom eines zu schützenden elektrischen Verbrauchers zur Erzeugung eines stromproportionalen Spannungssignales einem Verstärker und anschließend einem Integrator zugeführt wird, daß dieses Spannungssignal auf den Eingang der Quadrierschaltung gelegt wird, daß das Ausgangsstromsignal der Quadrierschaltung an deren RC-Netzwerk die Ausgangsspannung erzeugt, die anschließend einem Komparator zugeführt wird, und daß mittels des Ausgangssignals des Komparators eine Steuerung des Betriebszustandes des elektrischen Verbrauchers erfolgt.

In einer weiteren vorteilhaften Ausbildung einer solchen $i^2t$-Schutzschaltung wird der Ausgangsstrom der Quadrierschaltung so klein gewählt, daß mittels des Kondensators des RC-Netzwerkes eine Schutzfunktion auch bei intermittierendem Betrieb des elektrischen Verbrauchers sichergestellt ist.

Die Erfindung und ein Ausführungsbeispiel einer $i^2t$-Schutzschaltung wird anhand der Zeichnungen im einzelnen erläutert. Es zeigen:

die Figur 1 das Blockschaltbild der erfindungsgemäßen Quadrierschaltung, und

die Figur 2 das Blockschaltbild einer $i^2t$-Schutzschaltung mit der erfindungsgemäßen Quadrierschaltung nach Figur 1.

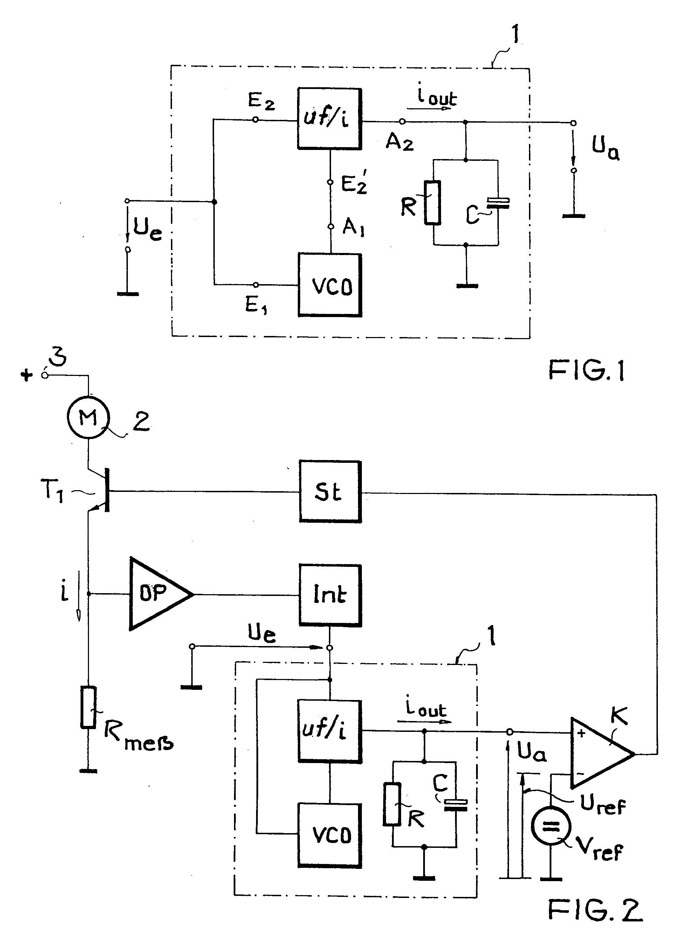

Der Quadrierschaltung 1 gemäß Figur 1 wird das Eingangsspannungssignal $U_e$, beispielsweise ein pulsweitenmoduliertes Gleichspannungssignal, über den Eingang $E_1$ dem spannungsgesteuerten Oszillator VCO zugeführt, der dieses Signal in ein Signal mit eingangsspannungsproportionaler Frequenz umwandelt und über seinen Ausgang $A_1$ dem Eingang $E_2'$ des Spannungs-Frequenz/Strom-Wandlers uf/i zuführt, an dessen zweiten Eingang $E_2$ ebenfalls das Eingangsspannungssignal $U_e$ anliegt. Dieser Spannungs-Frequenz/Strom-Wandler ist nach dem Prinzip der Ladungspumpe realisiert, indem im Takt der Ausgangsfrequenz f des spannungsgesteuerten Oszillators VCO ein Pumpenkondensator $C_p$ mit der Umladespannung $U_{cp}$ auf ein RC-Netzwerk umgeladen wird. Die Besonderheit des hier benötigten Wandlers liegt darin, daß der Pumpenkondensator dabei nicht wie üblich mit konstanter Spannung beaufschlagt wird, sondern daß die Spannung jeweils gleich der Eingangsspannung $U_e$ gemacht wird. Der Ausgangsstrom $i_{out}$ des Spannungs-Frequenz/Strom-Wandlers uf/i wird durch die zu umspeichernde Ladung bestimmt und berechnet sich nach folgender Formel:

$$i_{out} = f \cdot C_p \cdot U_{cp}. \quad (1)$$

Da die Ausgangsfrequenz f des spannungsgesteuerten Oszillators VCO proportional zur Eingangsspannung $U_e$ ist und auch $U_{cp} = U_e$ ist, ergibt sich eine quadratische Abhängigkeit des Ausgangsstromes $i_{out}$ von der Eingangsspannung $U_e$. Die Ausgangsspannung $U_a$ wird an einer Impedanz (R, C), vorzugsweise ein RC-Netzwerk, abgegriffen, die mit einem Anschluß mit dem Ausgang $A_2$ des Spannungs-Frequenz/Strom-Wandlers verbunden ist und mit ihrem anderen Anschluß auf Masse liegt. Somit ergibt sich zusammen mit der Formel (1) für die Ausgangsspannung $U_a$:

$$U_a = \overline{i_{out}} \cdot R = K_1 \cdot U_e^{\,2} \qquad (2)$$

wobei

$$\overline{i_{out}}$$

der gemittelte Ausgangsstrom ist und die Konstante $K_1$ von den Größen R, $C_p$ und f abhängt. Wegen der Beziehung (2) ist daher die Ausgangsspannung $U_a$ proportional zum Quadrat der Eingangsspannung $U_e$.

Die Figur 2 zeigt die Verwendung der erfindungsgemäßen Quadrierschaltung 1 nach Figur 1 in einer $i^2t$-Schutzschaltung, die zum Schutz einer Gleichstrommaschine 2 vor Überlastung als elektronische Sicherung arbeitet. Die Gleichstrommaschine 2 liegt mit ihrem ersten Anschluß an einer positiven Betriebsspannungsquelle 3 und ist mit ihrem anderen Anschluß mit der Kollektorelektrode eines Steuertransistors $T_1$ verbunden, dessen Emitterelektrode über einen Meßwiderstand $R_{meß}$ an Masse liegt. Der in diesem Laststromkreis fließende Laststrom i erzeugt einen Spannungsabfall an dem Meßwiderstand $R_{meß}$, dieser wird an dem Verbindungspunkt des Meßwiderstandes $R_{meß}$ und der Emitterelektrode des Steuertransistors $T_1$ abgenommen und zur Verstärkung auf einen Operationsverstärker OP geleitet. In einem Integrator Int wird dieses Signal integriert, um an dessen Ausgang das zum Laststrom proportionale Spannungssignal $U_e$ zu erhalten. Dieses Spannungssignal $U_e$ dient als Eingangsspannungssignal der nachgeschalteten erfindungsgemäßen Quadrierschaltung 1. Der Ausgang der Quadrierschaltung 1 ist mit dem nichtinvertierenden Eingang eines Komparators K verbunden, während dessen invertierender Eingang an einer Referenzspannungsquelle $V_{ref}$ liegt. Die an dem RC-Netzwerk (R, C) der Quadrierschaltung 1 abgegriffene Ausgangsspannung $U_a$ wird mit einer Schwellwertspannung $U_{ref}$ mittels des Komparators K verglichen. Der Ausgang des Komparators K ist mit einer Steuereinheit St verbunden, die die Basis des Steuertransistors $T_1$ ansteuert.

Aus der obigen Beziehung (2) ergibt sich wegen der Proportionalität der Eingangsspannung $U_e$ zum Laststrom i die quadratische Abhängigkeit des Ausgangsstromes $i_{out}$ von dem Laststrom i. Außerdem bildet die Zeitkonstante $\tau = R \cdot C$ des aus dem Widerstand R und dem Kondensator C gebildeten RC-Gliedes der Quadrierschaltung 1 das Zeitverhalten der Gleichstrommaschine 2 bezüglich der Temperatur nach. Nun kann der Schwellwert $U_{ref}$ der Referenzspannungsquelle $V_{ref}$ so gewählt werden, daß bei einer Überlastung der Gleichstrommaschine 2 die Ausgangsspannung $U_a$ den Schwellwert $_{ref}$ Übersteigt, und dadurch der Komparator K die Steuereinheit St so ansteuert, daß der Steuertransistor $T_1$ den Laststromkreis unterbricht, um hierdurch die Gleichstrommaschine 2 vor einer Zerstörung zu bewahren.

Während eines intermittierenden Betriebes der Gleichstrommaschine 2 würde die $i^2t$-Schutzschaltung bei kleiner Zeitkonstante $\tau$ des RC-Netzwerkes der Quadrierschaltung 1 immer von neuem an ihrem Anfangspunkt beginnen, wogegen die Gleichstrommaschine 2 schon eine gewisse Wärmeenergie gespeichert hat. Um auch noch bei diesem Betrieb eine Schutzfunktion sicherzustellen, sollte der Ausgangsstrom $i_{out}$ durch Wahl der Konstante $K_1$ sehr klein gewählt werden, um bei großem Widerstand R und vertretbaren Werten für den Kondensator C die zum Quadrat des Laststromes proportionale Ladung Q eine gewisse Zeitdauer in dem Kondensator C zu speichern. Diese Ladung Q stellt gewissermaßen ein Äquivalent der gespeicherten Wärmeenergie in der Gleichstrommaschine 2 dar, wobei durch entsprechende Wahl der Größen für den Widerstand R und den Kondensator C eine Zeitkonstante einstellbar ist, die das Abkühlverhalten der Gleichstrommaschine 2 nachbildet. Hierdurch kann gewährleistet werden, daß die i²t-Schutzschaltung während des intermittierenden Betriebes in etwa die aktuelle Betriebstemperatur der Gleichstrommaschine 2 berücksichtigt, wodurch ein ausreichender Schutz der Gleichstrommaschine 2 vor Überlastung erzielbar wird.

## Patentansprüche

1. Quadrierschaltung, die eine Ausgangsspannung ($U_a$) liefert, deren Wert proportional zum Quadrat des Wertes der Eingangsspannung ($U_e$) ist, gekennzeichnet durch einen spannungsgesteuerten Oszillator (VCO), der mit einem Spannungs-Frequenz/Strom-Wandler (uf/i), der sowohl einen frequenzproportionalen als auch spannungsproportionalen Strom liefert, verbunden ist, wobei dem spannungsgesteuerten Oszillator (VCO) und dem Spannungs-Frequenz/Strom-Wandler (uf/i) derart das Eingangsspannungssignal ($U_e$) zugeführt wird, daß der Spannungs-Frequenz/Strom-Wandler (uf/i) ein zum Quadrat der Eingangsspannung ($U_e$) proportionales Stromsignal ($i_{out}$) liefert, das mittels einer mit dem Ausgang des Spannungs-Frequenz/Strom-Wandlers (uf/i) verbundenen Impedanz (R, C) in das zum Stromsignal ($i_{out}$) proportionale Ausgangsspannungssignal ($U_a$) transformiert wird.

2. Quadrierschaltung nach Anspruch 1, dadurch gekennzeichnet, daß die Impedanz (R, C) ein RC-Netzwerk ist.

3. Quadrierschaltung nach Anspruch 1 oder 2, dadurch gekennzeichnet, daß der Spannungs-Frequenz/Strom-Wandler (uf/i) nach dem Prinzip der Ladungspumpe arbeitet.

4. Verwendung einer Quadrierschaltung nach einem der vorangehenden Ansprüche in einer i²t-Schutzschaltung zum Schutz eines elektrischen Verbrauchers vor Überlastung.

5. Verwendung der Quadrierschaltung nach Anspruch 4 in einer i²t-Schutzschaltung, dadurch gekennzeichnet, daß der über einen Meßwiderstand ($R_{meß}$) geführte Laststrom (i) eines zu schützenden elektrischen Verbrauchers (2) zur Erzeugung eines stromproportionalen Spannungssignales ($U_e$) einem Verstärker (OP) und anschließend einem Integrator (Int) zugeführt wird, daß dieses Spannungssignal ($U_e$) auf den Eingang der Quadrierschaltung (1) gelegt wird, daß das Ausgangsstromsignal ($i_{out}$) der Quadrierschaltung (1) an deren RC-Netzwerk (R, C) die Ausgangsspannung ($U_a$) erzeugt, die anschließend einem Komparator (K) zugeführt wird, und daß mittels des Ausgangssignales des Komparators (K) eine Steuerung des Betriebszustandes des elektrischen Verbrauchers (2) erfolgt.

6. Verwendung der Quadrierschaltung nach Anspruch 5 in einer i²t-Schutzschaltung, dadurch gekennzeichnet, daß der Ausgangsstrom ($i_{out}$) der Quadrierschaltung (1) so klein gewählt wird, daß mittels des Kondensators (C) des RC-Netzwerkes (R, C) eine Schutzfunktion auch bei intermittierendem Betrieb des elektrischen Verbrauchers sichergestellt ist.

## Claims

1. Squaring circuit which supplies an output voltage ($U_a$) whose value is proportional to the square of the value of the input voltage ($U_e$), characterised by a voltage-controlled oscillator (VCO) which is connected to a voltage-frequency/current converter (uf/i) that supplies both a frequency-proportional and a voltage-proportional current, in which the input voltage signal ($U_e$) is fed to the voltage-controlled oscillator (VCO) and to the voltage-frequency/current converter (uf/i) in such a way that the voltage-frequency/current converter (uf/i) supplies a current signal ($i_{out}$) proportional to the square of the input voltage ($U_e$), said current signal being transformed by means of an impedance (R, C) connected to the output of the voltage-frequency/current converter (uf/i) into the output voltage signal ($U_a$) proportional to the current signal ($i_{out}$).

2. Squaring circuit according to claim 1, characterised in that the impedance (R, C) is an RC network.

3. Squaring circuit according to claim 1 or 2, characterised in that the voltage-frequency/current converter (uf/i) works on the principle of the charging pump.

4. Use of a squaring circuit according to any one of the preceding claims in a i²t protective circuit for protecting an electric load against overloading.

5. Use of the squaring circuit according to claim 4 in a i²t protective circuit, characterised in that the load current (i), passed across a precision resistor ($R_{mess}$), of an electric load (2) to be protected is fed for the generation of a current-proportional voltage signal ($U_e$) to an amplifier (OP) and subsequently to an integrator (Int), that this voltage signal ($U_e$) is applied to the input of the squaring circuit (1), that the output current signal ($i_{out}$) of the squaring circuit (1) generates at the latter's RC network (R, C) the output voltage ($U_a$) which is subsequently fed to a comparator (K), and that by means of the output signal of the comparator (K) a control of the operating state of the electric load (2) takes place.

6. Use of the squaring circuit according to claim 5 in a $1^2$t protective circuit, characterised in that the output current ($i_{out}$) of the squaring circuit (1) is selected sufficiently small that by means of the capacitor (C) of the RC network (R, C) a protective function is ensured even with intermittent operation of the electric load.


## Revendications

1. Circuit d'élévation au carré fournissant une tension de sortie ($U_a$) dont la valeur est proportionnelle au carré de la valeur d'une tension d'entrée ($U_e$), caractérisé par un oscillateur commandé en tension (VCO) qui est relié à un convertisseur de tension-fréquence en courant (uf/i) qui fournit un courant à la fois proportionnel à la fréquence et proportionnel à la tension, le signal de tension d'entrée ($U_e$) étant injecté à l'oscillateur commandé en tension (VCO) au le convertisseur de tension-fréquence en courant (uf/i) de manière à ce que le convertisseur de tension-fréquence en courant (uf/i) génère un signal de courant ($i_{out}$), proportionnel au carré de la tension d'entrée ($U_e$), qui est transformé par une impédance (R, C) reliée à la sortie du convertisseur de tension-fréquence en courant (uf/i) en un signal de tension de sortie ($U_a$) proportionnel au signal de courant ($i_{out}$).

2. Circuit d'élévation au carré selon la revendication 1, caractérisé en ce que l'impédance (R, C) est un réseau RC.

3. Circuit d'élévation au carré selon la revendication 1 ou 2, caractérisé en ce que le convertisseur de tension-fréquence en courant (uf/i) fonctionne selon le principe de la pompe de charge.

4. Utilisation d'un circuit d'élévation au carré selon l'une des revendications précédentes dans un circuit de protection $i^2$t pour protéger des surcharges un consommateur électrique.

5. Utilisation du circuit d'élévation au carré selon la revendication 4 dans un circuit de protection $i^2$t, caractérisée en ce que le courant de charge (i) d'un consommateur électrique (2) à protéger passant par une résistance de mesure ($R_{mes}$) est injecté à un amplificateur (OP) pour générer un signal de tension ($U_e$) proportionnel au courant qui est ensuite envoyé à un circuit intégrateur (Int), en ce que ce signal de tension ($U_e$) est injecté à l'entrée du circuit d'élévation au carré (1), en ce que le signal de courant de sortie ($i_{out}$) du circuit d'élévation au carré (1) génère à la sortie du réseau RC (R, C) la tension de sortie ($U_a$) qui est ensuite injectée à un comparateur (K), et en ce que, à l'aide du courant de sortie du comparateur (K), on réalise une commande de l'état de fonctionnement du consommateur électrique (2).

6. Utilisation du circuit d'élévation au carré selon la revendication 5 dans un circuit de protection $i^2$t, caractérisée en ce que le courant de sortie ($i_{out}$) du circuit d'élévation au carré (1) est choisi assez petit pour que le condensateur (C) du réseau RC (R, C) assure une fonction de protection même en cas de fonctionnement intermittent du consommateur électrique.

FIG.1

FIG.2

6